# EUROPEAN PATENT SPECIFICATION

(11) **EP 4 024 705 B1**
(45) Date of publication and mention of the grant of the patent: **07.05.2025**
(21) Application number: 21211929.1
(22) Date of filing: 02.12.2021
(51) Int. Cl.: H03F 3/181, G06F 3/16, H03G 3/30, H03G 3/32

(54) **SPEECH SOUND RESPONSE DEVICE AND SPEECH SOUND RESPONSE METHOD**
SPRACHLAUTREAKTIONSVORRICHTUNG UND SPRACHLAUTREAKTIONSVERFAHREN
DISPOSITIF ET PROCÉDÉ DE RÉPONSE À UN SON VOCAL

(30) Priority: 04.01.2021 JP 2021000096
(43) Date of publication of application: 06.07.2022
(73) Proprietor: Toshiba TEC Kabushiki Kaisha, Tokyo 141-8562 (JP)
(72) Inventor: Sekine, Naoki, Shinagawa-ku, Tokyo 141-8562 (JP)
(74) Representative: Bandpay & Greuter

(56) References cited:
- JP-A- 2014 202 808
- JP-A- 2018 194 832
- US-A1- 2012 271 630
- US-A1- 2020 034 108
- US-A1- 2020 075 036
- US-A1- 2020 388 268

## Description

### FIELD

Embodiments described herein relate generally to a speech sound response device and a speech sound response method, as well as a computer program product.

### BACKGROUND

A speech sound dialogue device (a speech sound response device) such as an artificial intelligence (Al) speaker (smart speaker) inputs a voice uttered by the user as an input speech sound and performs speech sound recognition on the content of the received input speech sound. The speech sound dialogue device outputs response content generated in response to the result of the speech sound recognition with respect to the input speech sound as a response speech sound. Generally, if the volume of the input speech sound is too loud, or the volume of the input speech sound is too low, it is difficult for the speech sound dialogue device to obtain a correct recognition result by the speech sound recognition. It is considered that the speech sound dialogue device is likely to control the loudness of the voice uttered by a talker (user) by controlling the volume of the output response speech sound. This is because the talker may control the loudness of the voice to be uttered in response to the loudness of a voice of a partner to talk to.

However, the speech sound dialogue device in the related art cannot flexibly change the volume of the response speech sound because the response speech sound has a preset volume or a volume defined by the user. Further, the speech sound dialogue device uses a microphone to collect not only the talker's voice but also sounds other than the talker's voice. Therefore, the speech sound dialogue device has a problem that it is difficult to improve the accuracy of speech sound recognition even if the volume of the response speech sound can be simply set in response to the volume of the input speech sound. The prior art document US 2020/388268 A1 (SAITO MARI [JP]) 10 December 2020 (2020-12-10), document US 2020/075036 A1 (SHIN MYEONGSOO [KR]) 5 March 2020 (2020-03-05), document US 2012/271630 A1 (MIKI KIYOKAZU [JP]) 25 October 2012 (2012-10-25) and document US 2020/034108 A1 (MOZER TODD F [US]) 30 January 2020 (2020-01-30) disclose the most relevant teachings concerning adaptation of the response speech sound volume.

### DESCRIPTION OF THE DRAWINGS

FIG. 1 is a diagram schematically illustrating a configuration example of a speech sound response device according to an embodiment;
FIG. 2 is a block diagram illustrating a configuration example of a control system;
FIG. 3 is a diagram illustrating an example of a function for determining a response volume from an input volume if an environmental volume is less than a threshold value;
FIG. 4 is a diagram illustrating an example of a function for determining the response volume from the input volume if the environmental volume is the threshold value or more;
FIG. 5 is a diagram illustrating an example of a table for selecting a function in response to the environmental volume and the input volume;
FIG. 6 is a flowchart for explaining an operation example;
FIG. 7 is a flowchart for explaining a calculating process of a response volume; and
FIG. 8 is a flowchart for explaining the calculating process of the response volume.

### DETAILED DESCRIPTION

In order to solve the above problem, a speech sound response device and a speech sound response method that can realize a highly accurate speech sound response are provided.

There is provided a speech sound response device comprising a microphone configured to acquire sound, a speaker, and a processor. The processor is configured to: detect a voice in the sound; generate a response to the voice; determine a response volume for outputting the response based on (i) a voice volume of the voice in the sound and (ii) an environmental volume of an environmental sound other than the voice; and control the speaker to output the response at the response volume.

According to the invention, the speech sound response device further comprises a storage device configured to store a plurality of volume functions. Each of the plurality of volume functions (i) corresponds to a loudness of the environmental volume of the environmental sound and (ii) relates the response volume to a loudness of the voice volume. The processor is configured to select one of the plurality of volume functions based on the environmental volume and determine the response volume of the response using the one of the plurality of volume functions based on the voice volume.

Preferably the speech sound response device further comprises a memory configured to store the environmental volume of the environmental sound. The processor is configured to: monitor the sound acquired by the microphone; determine the environmental volume from the sound in response to not detecting the voice in the sound; store the environmental volume in the memory; and determine the response volume of the response based on the voice volume detected in the sound and the environmental volume of the environmental sound stored in the memory.

Preferably, the processor is configured to determine the environmental volume periodically from the sound.

Preferably, the processor is configured to determine the environmental volume based on an average volume of the environmental sound over a period of time.

There is also provided a speech sound response method using a speech sound response device. The method comprises: acquiring, by a processor, a sound input from a microphone; detecting, by the processor, a voice in the sound input; generating, by the processor, a response to the voice; determining, by the processor, a response volume for outputting the response based on (i) a voice volume of the voice in the sound input and (ii) an environmental volume of an environmental sound other than the voice; and controlling, by the processor, a speaker to output the response at the response volume.

According to the invention, the method further comprises: storing, by the processor, a plurality of volume functions in a memory, wherein each of the plurality of volume functions (i) corresponds to a loudness of the environmental volume of the environmental sound and (ii) relates the response volume to a loudness of the voice volume; and selecting, by the processor, one of the plurality of volume functions based on the environmental volume; and determining, by the processor, the response volume of the response using the one of the plurality of volume functions and the voice volume.

Preferably the method further comprises: monitoring, by the processor, the sound input acquired from the microphone; determining, by the processor, the environmental volume from the sound input in response to not detecting the voice in the sound input; store the environmental volume in a memory; and determine the response volume of the response based on the voice volume detected in the sound input and the environmental volume of the environmental sound stored in the memory.

Preferably, the processor is configured to determine the environmental volume periodically from the sound input.

Preferably, the processor is configured to determine the environmental volume based on an average volume of the environmental sound over a period of time.

There is also provided a computer program product comprising instructions which, when the program is executed by a computer, cause the computer to carry out the steps of the method described above.

In general, according to one embodiment, a speech sound response device includes a microphone, a processor, and a speaker. The microphone inputs a sound. The processor generates a response content by a speech sound in response to a voice uttered by a user to be detected from the sound input by the microphone and determines a volume for outputting the response content as a response speech sound in response to an input volume as a volume of the voice uttered by the user and a volume of an environmental sound other than the voice uttered by the user. The speaker outputs the response speech sound in the volume determined by the processor.

Hereinafter, the embodiment is described with reference to the drawings.

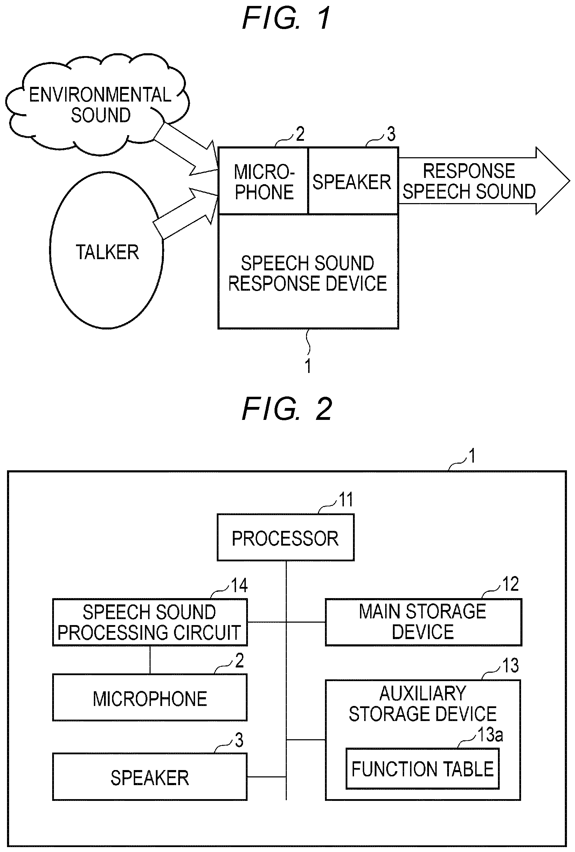

FIG. 1 is a diagram schematically illustrating the speech sound response device 1 according to the embodiment. As illustrated in FIG. 1, the speech sound response device 1 according to the embodiment includes a microphone 2 and a speaker 3. The speech sound response device 1 is a device that outputs a response speech sound from the speaker 3 in response to the speech sound of the talker input to the microphone 2.

The speech sound response device 1 is, for example, a speech sound dialogue device referred to as an AI speaker. The speech sound response device 1 may be an information process device such as a smartphone, a tablet terminal, or a personal computer. The speech sound response device 1 may be a device obtained by connecting any one or both of the microphone 2 and the speaker 3 to the information process device.

The speech sound response device 1 collects a sound including a voice uttered by a talker (speech sound) and the environmental sound with the microphone 2. The speech sound response device 1 detects the voice uttered by the talker (input speech sound) from the sound collected with the microphone 2. The speech sound response device 1 recognizes the content of the input speech sound (the content of the talk uttered by the talker) by performing speech sound recognition on the detected input speech sound. The speech sound response device 1 generates the response content uttered as the response speech sound in response to the content of the recognized input speech sound.

Further, the speech sound response device 1 according to the present embodiment measures (calculates) the volume of the voice uttered by the talker (input speech sound) and the volume of the sound other than the voice uttered by the talker (environmental sound). The speech sound response device 1 holds a plurality of functions (or tables) for determining the volume of the response speech sound. The plurality of functions in order to determine the volume of the response speech sound is set in response to the combination of the loudness of the environmental sound and the loudness of the input speech sound. The speech sound response device 1 selects the function (or the table) based on the volume of the input speech sound and the volume of the environmental sound measured from the sound collected with the microphone 2. The speech sound response device 1 determines the volume of the response speech sound in response to the volume of the input speech sound according to the selected function. The speech sound response device outputs the response content generated in response to the content of the input speech sound as the response speech sound of the volume determined from the volume of the input speech sound and the volume of the environmental sound from the speaker 3.

Subsequently, the configuration of the speech sound response device 1 according to the embodiment is described. FIG. 2 is a block diagram illustrating the configuration example of the speech sound response device 1 according to the embodiment. As illustrated in FIG. 2, the speech sound response device 1 includes a processor 11, a main storage device 12, an auxiliary storage device 13, a speech sound processing circuit 14, the microphone 2, and the speaker 3.

The processor 11 controls the entire speech sound response device 1. The processor 11 is, for example, a central processing unit (CPU). The processor 11 performs various processes described below by executing programs. For example, the processor 11 performs various processes such as operation control of the speech sound response device 1, speech sound detection, speech sound recognition, response sentence generation, input speech sound volume measurement, environmental sound volume measurement, response speech sound volume calculation, and response waveform generation.

The main storage device 12 is a main memory that stores data. The main storage device 12 is, for example, configured with a random-access memory (RAM). The main storage device 12 temporarily stores data during the process by the processor 11. The main storage device 12 may store data required for executing a program and an execution result of the program. The main storage device 12 also operates as a buffer memory for temporarily holding data.

For example, the main storage device 12 functions as a memory that stores, for example, information indicating the volume of the environmental sound calculated from the sound collected with the microphone. For example, the main storage device 12 stores data of the speech sound obtained by processing the sound collected with the microphone 2 by the speech sound processing circuit 14. Further, the main storage device 12 may store the calculation result of the volume of the voice uttered by talker (input speech sound) included in the sound collected with the microphone 2. The main storage device 12 may store the information indicating the volume of the response speech sound determined in response to the volume of the input speech sound and the volume of the environmental sound.

The auxiliary storage device 13 is storage that stores data. The auxiliary storage device 13 includes a non-rewritable non-volatile memory such as a read-only memory (ROM), a rewritable non-volatile memory, and the like. Examples of the rewritable non-volatile memory include a hard disk drive (HDD), a solid state drive (SSD), an electrically erasable programmable read-only memory (EEPROM) (registered trademark), or a flash ROM.

The auxiliary storage device 13 stores a program executed by the processor 11 and control data. For example, the auxiliary storage device 13 stores a speech sound response program in order to output the response speech sound in response to the input speech sound. The speech sound response program includes programs that perform various processes as described below such as speech sound detection, speech sound recognition, intention analysis, response sentence generation, input volume calculation, environmental volume calculation, response volume calculation, and response waveform generation. In addition, a portion or all of the processes performed by executing the programs by the processor 11 described below may be performed by hardware such as processing circuits.

In the example illustrated in FIG. 2, the auxiliary storage device 13 adds the volume of the environmental sound (environmental volume) and stores a function table 13a in order to select a function for determining the volume of the response speech sound in response to the volume of the input speech sound (input volume). The function table 13a is specifically described below.

The microphone 2 collects (acquires) a sound. The microphone 2 inputs, for example, a collected sound as an analog signal (analog waveform) and outputs the analog signal of the input sound to the speech sound processing circuit 14. The speech sound processing circuit 14 receives the analog signal of the sound collected by the microphone 2 and outputs sound data as digital data obtained by digitalizing the analog signal of the input sound. The speech sound processing circuit 14 includes an AD converter or the like that digitalizes an analog waveform. The microphone 2 may be an external device connected to the speech sound response device 1. If the microphone 2 is an external device, the speech sound processing circuit 14 may include an interface that connects the microphone 2 for receiving a speech sound.

The speaker 3 outputs a speech sound. The speaker 3 utters a response speech sound based on the response waveform supplied from the processor 11. The speaker 3 controls a volume by the processor 11. For example, the speaker 3 utters a response speech sound based on the response waveform of which the amplitude is adjusted by the processor 11 in response to the volume of the response speech sound. The speaker 3 may be an external device connected to the speech sound response device 1. If the speaker 3 is an external device, the speech sound response device 1 may include an interface that outputs a signal indicating a waveform of a sound to be output to the speaker 3.

Subsequently, a function for determining a volume of a response speech sound (response volume) by the speech sound response device 1 according to the embodiment is described. The speech sound response device 1 recognizes the voice uttered by the talker and outputs a response to the speech uttered by the talker (input sentence) by a speech sound. The speech sound response device 1 generates the response content with respect to the voice uttered by the talker and also determines the response volume by using the function selected in response to the volume of the input speech sound (input volume) and the volume of the environmental sound (environmental volume). That is, the speech sound response device 1 holds the plurality of functions in response to the loudness of the environmental sound as the function for determining the response volume from the input volume. The speech sound response device 1 selects the function appropriate for the loudness of the environmental sound from the plurality of functions and determines the response volume from the input volume.

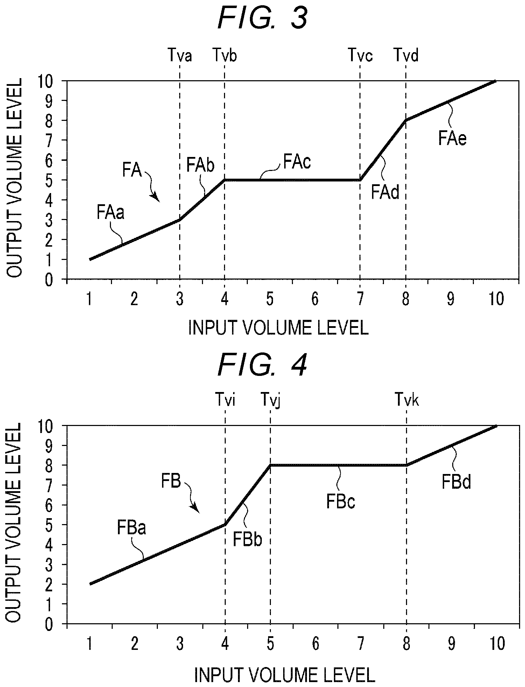

FIGS. 3 and 4 are diagrams illustrating examples of functions (filters) for determining the volume of the response speech sound (response volume) in response to a volume V of the input speech sound (input volume). FIG. 3 illustrates an example of a function (first function) for determining a response volume from the input volume if a volume (environmental volume) S of the environmental sound is less than the threshold value Ts (S < Ts). FIG. 4 illustrates an example of a function (second function) for determining a response volume from the input volume if the environmental volume S is a threshold value Ts or more (S ≥ Ts).

In the example illustrated in FIG. 3, a function FA is a function for determining the response volume from the input volume if the environmental volume S is less than the threshold value Ts (S < Ts). The function FA changes characteristics by threshold values Tva, Tvb, Tvc, and Tvd with respect to the input volume V. The function FA includes functions FAa, FAb, FAc, FAd, and FAe in five sections separated by four threshold values Tva, Tvb, Tvc, and Tvd with respect to the input volume V.

The function FAa is a function for determining the response volume from the input volume if the environmental volume S is less than the threshold value Ts (S < Ts), and the input volume V is less than the threshold value Tva (V < Tva). The function FAb is a function for determining the response volume from the input volume if the environmental volume S is less than the threshold value Ts (S < Ts), and the input volume V is the threshold value Tva or more and less than the threshold value Tvb (Tva ≤ V < Tvb).

The function FAc is a function for determining the response volume from the input volume if the environmental volume S is less than the threshold value Ts (S < Ts), and the input volume V is the threshold value Tvb or more and less than the threshold value Tvc (Tvb ≤ V < Tvc). The function FAd is a function for determining the response volume from the input volume if the environmental volume S is less than the threshold value Ts (S < Ts), and the input volume V is the threshold value Tvc or more and less than the threshold value Tvd (Tvc ≤ V < Tvd). The function FAe is a function for determining the response volume from the input volume if the environmental volume S is less than the threshold value Ts (S < Ts), and the input volume V is the threshold value Tvd or more (Tvd ≤ V).

In the example illustrated in FIG. 4, a function FB is a function for determining the response volume from the input volume if the environmental volume S is the threshold value Ts or more (Ts ≤ S). The function FB changes characteristics by three threshold values Tvi, Tvj, and Tvk with respect to the input volume V. The function FB includes the functions FBa, FBb, FBc, and FBd in four sections separated by three threshold values Tvi, Tvj, and Tvk with respect to the input volume V.

The function FBa is a function for determining the response volume from the input volume if the environmental volume S is the threshold value Ts or more (Ts ≤ S), and the input volume V is less than the threshold value Tvi (V < Tvi). The function FBb is a function for determining the response volume from the input volume if the environmental volume S is the threshold value Ts or more (Ts ≤ S), and the input volume V is the threshold value Tvi or more and less than the threshold value Tvj (Tvi ≤ V < Tvj).

The function FBc is a function for determining the response volume from the input volume if the environmental volume S is the threshold value Ts or more (Ts ≤ S), and the input volume V is the threshold value Tvj or more and less than the threshold value Tvk (Tvj ≤ V < Tvk). The function FBd is a function for determining the response volume from the input volume if the environmental volume S is the threshold value Ts or more (Ts ≤ S), and the input volume V is the threshold value Tvk or more (Tvk ≤ V).

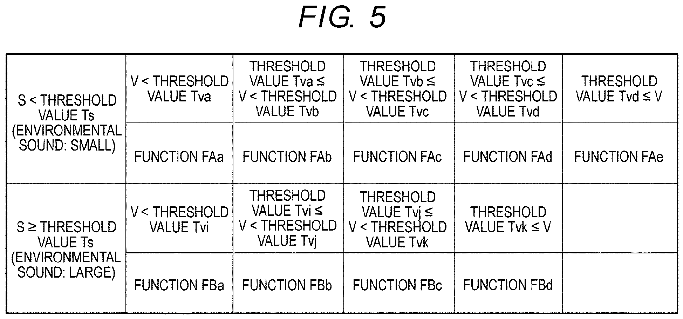

FIG. 5 is a diagram illustrating a configuration example of the function table 13a for selecting a function appropriate for the loudness of the environmental volume S and the input volume V by the speech sound response device 1 according to the embodiment. The function table 13a illustrated in FIG. 5 shows functions to be selected in response to the loudness of the environmental volume S and the input volume V from the functions illustrated in FIGS. 3 and 4. The function table 13a illustrated in FIG. 5 is stored, for example, in the auxiliary storage device 13 in the speech sound response device 1 as illustrated in FIG. 2. The speech sound response device 1 selects one function in response to the environmental volume S and the input volume V with reference to the function table 13a. The speech sound response device 1 determines the response volume from the input volume by using the function selected in response to the environmental volume S and the input volume V.

For example, if S < Ts and V < Tva, the speech sound response device 1 determines the response volume from input volume by using the function FAa. If S < Ts and Tva ≤ V < Tvb, the speech sound response device 1 determines the response volume from input volume by using the function FAb. If S < Ts and Tvb ≤ V < Tvc, the speech sound response device 1 determines the response volume from input volume by using the function FAc. If S < Ts and Tvc ≤ V < Tvd, the speech sound response device 1 determines the response volume from input volume by using the function FAd. If S < Ts and Tvd ≤ V, the speech sound response device 1 determines the response volume from input volume by using the function FAe.

If Ts ≤ S and V < Tvi, the speech sound response device 1 determines the response volume from input volume by using the function FBa. If Ts ≤ S and Tvi ≤ V < Tvj, the speech sound response device 1 determines the response volume from input volume by using the function FBb. If Ts ≤ S and Tvj ≤ V < Tvk, the speech sound response device 1 determines the response volume from input volume by using the function FBc. If Ts ≤ S and Tvk ≤ V, the speech sound response device 1 determines the response volume from input volume by using the function FBd.

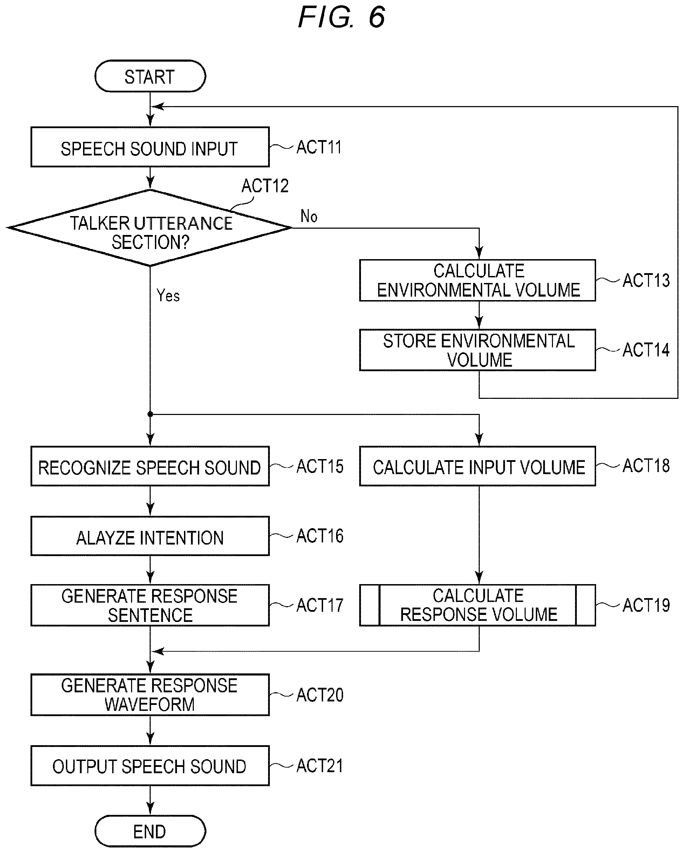

Subsequently, the operation of the speech sound response device 1 according to the embodiment is described. FIG. 6 is a flowchart for explaining an operation example of a process of outputting a response speech sound to a voice of a talker (user) by the speech sound response device 1 according to the embodiment. The processor 11 of the speech sound response device 1 inputs the sound collected by the microphone 2 as the sound data of the input sound (ACT 11). The microphone 2 supplies the signal indicating the analog waveform of the collected sound to the speech sound processing circuit 14. The speech sound processing circuit 14 digitalizes the signal indicating the analog waveform input from the microphone 2. The speech sound processing circuit 14 supplies the digitalized digital signal as sound data to the processor 11. The processor 11 acquires the sound data of the input sound obtained by digitalizing the sound collected by the microphone 2 with the speech sound processing circuit 14.

If the sound data of the input sound is acquired, the processor 11 detects whether the voice uttered by the talker (talker's voice) is included in the sound data of the input sound by the speech sound detection process (ACT 12). The processor 11 performs the speech sound detection process of detecting whether the voice uttered by the talker is included in the input sound by executing the speech sound detection program.

If the talker's voice is not detected from the input sound (ACT 12, NO), the processor 11 calculates (measures) the volume of the environmental sound (environmental volume) from the sound data of the input sound (ACT 13). If the talker's voice is not detected from the input sound, the input sound is set as an environmental sound (a sound other than the talker's voice) not including the talker's voice. If the input sound is the environmental sound, the processor 11 calculates the volume from the sound data of the input sound. If the input sound is the environmental sound, the processor 11 stores the volume of the calculated input sound to the main storage device 12 or the auxiliary storage device 13 as the environmental volume S (ACT 14).

In the present embodiment, the processor 11 stores the volume calculated from the input sound (environmental sound) in a period if the talker's voice is not included as the environmental volume S in order to estimate the environmental volume if the talker utters a voice. Therefore, the processor 11 may overwrite and store the environmental volume previously stored (the environmental volume in the past) with the calculated environmental volume S. The processor 11 may store the environmental volume S in a predetermined period from the present (e.g., periodically). Further, the processor 11 may store an average value of the environmental volume calculated in the predetermined period from the present as the environmental volume S.

If the talker's voice is detected from the input sound (ACT 12, YES), the processor 11 performs the process of generating the response content (response sentence) (ACTS 15 to 17) and the process of calculating the response volume (ACTS 18 to 19).

As the process of generating the response content, the processor 11 performs processes such as a speech sound recognition process, a content analysis process, and a response sentence generation process. That is, the processor 11 performs the speech sound recognition of recognizing the talker's voice (input speech sound) included in the input sound (ACT 15). The processor 11 extracts the talker's voice from the input sound and recognizes the speech uttered by the talker (input sentence) from the extracted talker's voice. For example, the processor 11 recognizes the speech uttered by the talker by referring to the pronunciation of a preset language (word).

When obtaining the input sentence as the speech sound recognition result of the voice uttered by the talker, the processor 11 performs the intention analysis process of analyzing the meaning of the input sentence obtained as the speech sound recognition result (ACT 16). The processor 11 analyzes the meaning of the input sentence (the intention of the user included in the input sentence) based on the recognition result of the word included in the input sentence as the intention analysis process.

For example, the processor 11 determines whether the input sentence is a question sentence, a request or a wish, a greeting, or the like. If the input sentence is determined to be the question sentence, the processor 11 specifies the question content included in the input sentence. In addition, if it is determined that the input sentence is a request, the processor 11 specifies the content of the request included in the input sentence. If it is determined that the input sentence is a greeting, the processor 11 specifies the content of the greeting included in the input sentence.

If the meaning of the voice uttered by the talker (input sentence) is analyzed, the processor 11 generates the response content (response sentence) with respect to the input sentence (ACT 17). For example, if the question content included in the input sentence is specified, the processor 11 generates the response sentence in response to the question content. If the request of the talker included in the input sentence is specified, the processor 11 generates the response sentence according to the request of the talker. If the greeting included in the input sentence is specified (if it is understood that the input sentence is a greeting from the talker), the processor 11 generates a response sentence as the greeting in response to the greeting from the talker.

Meanwhile, the processor 11 performs the calculating process of the input volume V and the calculating process of the response volume as the process of calculating the response volume. The processor 11 calculates the volume V of the talker's voice detected from the input sound (input speech sound) (ACT 18). For example, the processor 11 extracts the component of the talker's voice from the sound data of the input sound (input speech sound) and calculates the volume V of the extracted input speech sound (input volume).

If the input volume V is calculated, the processor 11 performs a process of calculating the response volume based on the calculated input volume V and the environmental volume S (ACT 19). The processor 11 calculates the response volume with respect to the input volume based on the function to be selected in response to the input volume V and the environmental volume S. The process of calculating the response volume (the calculating process of the response volume) is specifically described below.

The processor 11 generates the response waveform to be the response speech sound uttered from the speaker 3 based on the response sentence generated in ACT 17 and the response volume calculated in ACT 19 (ACT 20). For example, the processor 11 generates the response waveform for uttering the response sentence generated in ACT 17 as the response speech sound. The processor 11 adjusts the amplitude of the response waveform for uttering the generated response speech sound in response to the response volume calculated in ACT 19. If the response waveform is generated, the processor 11 outputs the generated response waveform from the speaker 3 (ACT 21).

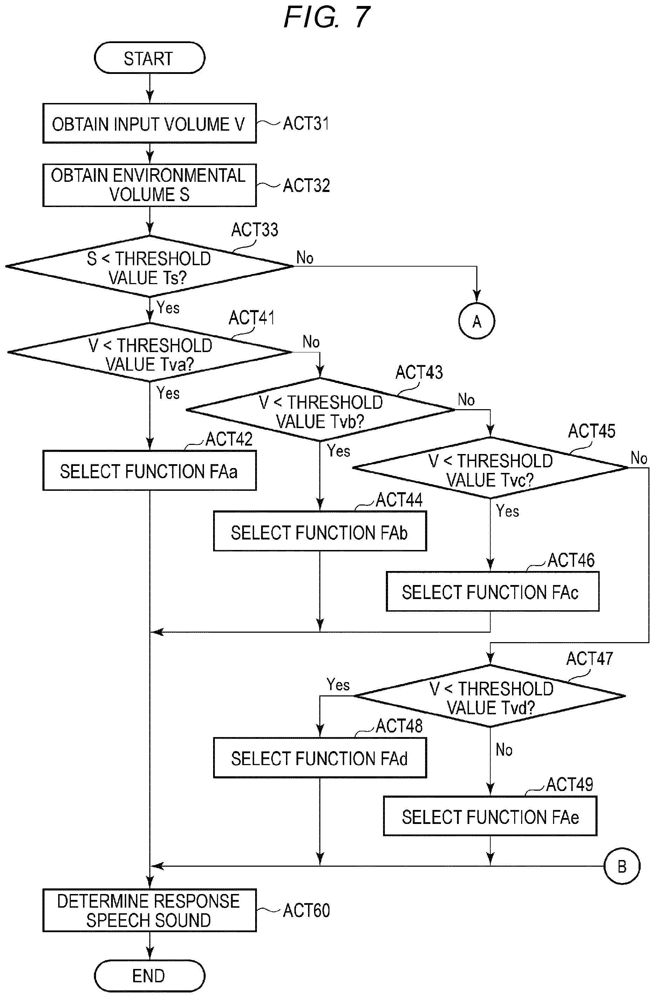

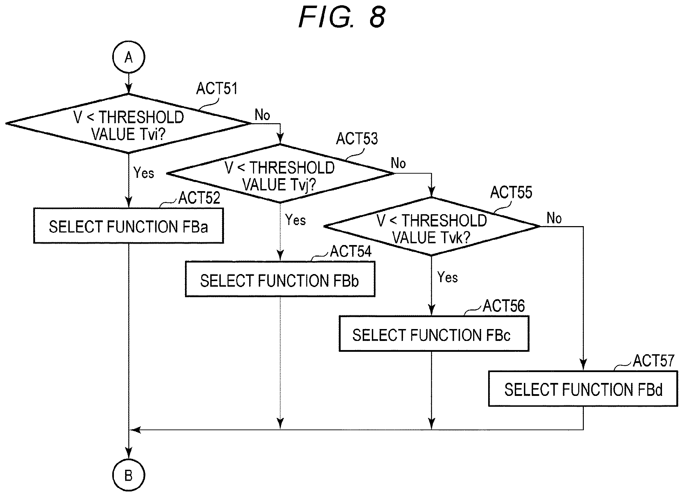

Subsequently, the calculating process of the response volume in the speech sound response device 1 according to the embodiment is specifically described. FIGS. 7 and 8 are flowcharts for explaining the calculating process of the response volume in the speech sound response device 1 according to the embodiment. In the calculating process of the response volume, the processor 11 acquires the input volume V in the present to be calculated in ACT 18 described above (ACT 31). The processor 11 acquires the environmental volume S stored in the main storage device 12 or the auxiliary storage device 13 (ACT 32).

If the input volume V and the environmental volume S are acquired, the processor 11 selects the function in response to the input volume V and the environmental volume S with reference to the function table illustrated in FIG. 5. In the process examples illustrated in FIGS. 7 and 8, the processor 11 selects the function according to the function table 13a illustrated in FIG. 5. The functions for adding the environmental volume and determining the response volume from the input volume are not limited to those illustrated in FIGS. 3 and 4 and can be appropriately set in response to operation forms. In addition, the threshold value with respect to the environmental volume and the threshold value with respect to the input volume are not limited to those illustrated in FIGS. 3, 4, and 5, and may be appropriately set in response to the functions.

In the process examples illustrated in FIGS. 7 and 8, the processor 11 refers to the table illustrated in FIG. 5 and determines whether the environmental volume S is less than the threshold value Ts (ACT 33). If the environmental volume S is less than the threshold value Ts (S < Ts) (ACT 33, YES), the processor 11 applies the function FA (i.e., if the environmental volume S is low). According to the example illustrated in FIG. 3, the function FA includes five functions FAa, FAb, FAc, FAd, and FAe separated by the threshold values Tva, Tvb, Tvc, and Tvd. Based on the table illustrated in FIG. 5, the processor 11 compares the input volume V with the threshold values Tva, Tvb, Tvc, and Tvd and selects one function from the functions FAa, FAb, FAc, FAd, and FAe.

That is, if S < Ts (ACT 33, YES), the processor 11 determines whether the input volume V is less than the threshold value Tva (ACT 41). If it is determined that the input volume V is less than the threshold value Tva (ACT 41, YES), the processor 11 specifies that S < Ts, and V < Tva. If S < Ts, and V < Tva, the processor 11 selects the function FAa (ACT 42).

If it is determined that the input volume V is not less than the threshold value Tva (ACT 41, NO), the processor 11 determines whether the input volume V is less than the threshold value Tvb (ACT 43). If it is determined that the input volume V is less than the threshold value Tvb (ACT 43, YES), the processor 11 specifies that S < Ts, and Tva ≤ V < Tvb. If S < Ts, and Tva ≤ V < Tvb, the processor 11 selects the function FAb (ACT 44).

If it is determined that the input volume V is not less than the threshold value Tvb (ACT 43, NO), the processor 11 determines whether the input volume V is less than the threshold value Tvc (ACT 45). If it is determined that the input volume V is less than the threshold value Tvc (ACT 45, YES), the processor 11 specifies that S < Ts, and Tvb ≤ V < Tvc. If S < Ts, and Tvb ≤ V < Tvc, the processor 11 selects the function FAc (ACT 44).

If it is determined that the input volume V is not less than the threshold value Tvc (ACT 45, NO), the processor 11 determines whether the input volume V is less than the threshold value Tvd (ACT 47). If it is determined that the input volume V is less than the threshold value Tvd (ACT 47, YES), the processor 11 specifies that S < Ts, and Tvc ≤ V < Tvd. If S < Ts, and Tvc ≤ V < Tvd, the processor 11 selects the function FAd (ACT 48).

If it is determined that the input volume V is not less than the threshold value Tvd (ACT 47, NO), since the input volume V is the threshold value Tvd or more, the processor 11 specifies that S < Ts, and Tvd ≤ V If S < Ts, and Tvd ≤ V, the processor 11 selects the function FAe (ACT 49).

Meanwhile, if the environmental volume S is not less than the threshold value Ts, that is, if the environmental volume S is the threshold value Ts or more (ACT 33, NO), the processor 11 applies the function FB (i.e., when the environmental volume S is high). According to the example illustrated in FIG. 4, the function FB includes four functions FBa, FBb, FBc, and FBd separated by the threshold values Tvi, Tvj, and Tvk with respect to the input volume V. Based on the function table 13a illustrated in FIG. 5, the processor 11 compares the input volume V with the threshold values Tvi, Tvj, and Tvk and selects one function from the functions FBa, FBb, FBc, and FBd.

That is, if S < Ts is not satisfied (ACT 33, NO), the processor 11 determines whether the input volume V is less than the threshold value Tvi (ACT 51). If it is determined that the input volume V is less than the threshold value Tvi (ACT 51, YES), the processor 11 specifies that S ≥ Ts, and V < Tvi. If S ≥ Ts, and V < Tvi, the processor 11 selects the function FBa (ACT 52).

If it is determined that the input volume V is not less than the threshold value Tvi (ACT 51, NO), the processor 11 determines whether the input volume V is less than the threshold value Tvj (ACT 53). If it is determined that the input volume V is less than the threshold value Tvj (ACT 53, YES), the processor 11 specifies that S ≥ Ts, and Tvi ≤ V < Tvj. If S ≥ Ts, and Tvi ≤ V < Tvj, the processor 11 selects the function FBb (ACT 54).

If it is determined that the input volume V is not less than the threshold value Tvj (ACT 53, NO), the processor 11 determines whether the input volume V is less than the threshold value Tvk (ACT 55). If it is determined that the input volume V is less than the threshold value Tvk (ACT 55, YES), the processor 11 specifies that S ≥ Ts, and Tvj ≤ V < Tvk. If S < Ts, and Tvj ≤ V < Tvk, the processor 11 selects the function FBc (ACT 56).

If it is determined that the input volume V is not less than the threshold value Tvk (ACT 55, NO), since the input volume V is the threshold value Tvk or more, the processor 11 specifies that S ≥ Ts, and Tvk ≤ V If S ≥ Ts, and Tvk ≤ V, the processor 11 selects the function FBd (ACT 57).

If the function is selected in response to the environmental volume S and the input volume V, the processor 11 determines the response speech sound based on the selected function (ACT 60). That is, the processor 11 calculates the response volume in response to the input volume V in the selected function. Accordingly, the processor 11 can add the environmental volume and calculate the response volume in response to the input volume.

As above, the speech sound response device according to the embodiment detects the voice uttered by the user from the sound input to the microphone. The speech sound response device generates the response content (response sentence) to be output as the response speech sound with respect to the voice uttered by the user. Further, the speech sound response device calculates the response volume in response to the input volume as the volume of the voice uttered by the user and the volume of the environmental sound other than the voice uttered by the user. The speech sound response device outputs the response speech sound from the speaker in the calculated response volume.

That is, the speech sound response device according to the embodiment can add the loudness of the environmental sound and output the response speech sound of the response volume in response to the input volume. Accordingly, it can be expected that the loudness of the voice uttered by the talker (user) is controlled in response to the volume of the response speech sound output by the speech sound response device. The speech sound response device can guide the loudness of the voice uttered by the user to the volume appropriate for the speech sound recognition so that the speech sound recognition with the high accuracy can be realized.

The speech sound response device according to the embodiment holds the plurality of functions selected in response to the loudness of the environmental volume. The speech sound response device determines the volume of the response speech sound from the input volume based on the first function if the environmental volume is less than the threshold value and determines the volume of the response speech sound from the input volume based on the second function different from the first function if the environmental volume is less than the threshold value. Accordingly, the speech sound response device according to the embodiment can set the response volume in response to the loudness of the environmental sound. As a result, even in an environment where the environmental volume cannot be predicted in advance, the speech sound response device can guide the loudness of the voice uttered by the user to the volume appropriate for the speech sound recognition.

The speech sound response device according to the embodiment stores the plurality of functions to be selected in response to the loudness of the environmental volume and the loudness of the input volume in the storage device. The speech sound response device determines the volume of the response speech sound from the input volume based on one function selected in response to the environmental volume and the input volume from the plurality of functions. Accordingly, the speech sound response device can select the function in response to the environmental volume and the input volume and can guide the loudness of the voice uttered by the user to the volume appropriate for the speech sound recognition.

In the above embodiment, the case where the program executed by the processor is stored in advance in the memory in the device is described. However, the program executed by the processor may be downloaded from the network to the device or may be installed from the storage medium to the device. The storage medium may be a storage medium that can store a program such as a CD-ROM and can be read by the device. Further, the functions obtained by installation or download in advance may be realized in cooperation with the operating system (OS) or the like inside the device.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the scope of the inventions. These embodiments and modifications of the embodiments are included in the scope of the invention and included in the inventions described in claims.

## Claims

1. A speech sound response device comprising (1):
a microphone (2) configured to acquire sound;
a speaker (3); and
a processor (11) configured to:
detect a voice in the sound;
generate a response to the voice;
determine a response volume for outputting the response based on (i) a voice volume of the voice in the sound and (ii) an environmental volume of an environmental sound other than the voice; and
control the speaker to output the response at the response volume, the speech sound response device being **characterized in that** it further comprises a storage device configured to store a plurality of volume functions, wherein each of the plurality of volume functions (i) corresponds to a loudness of the environmental volume of the environmental sound and (ii) relates the response volume to a loudness of the voice volume, and wherein the processor is configured to select one of the plurality of volume functions based on the environmental volume and determine the response volume of the response using the one of the plurality of volume functions based on the voice volume.

2. The speech sound response device according claim 1, further comprising a memory configured to store the environmental volume of the environmental sound, wherein the processor is configured to:
monitor the sound acquired by the microphone;
determine the environmental volume from the sound in response to not detecting the voice in the sound;
store the environmental volume in the memory; and
determine the response volume of the response based on the voice volume detected in the sound and the environmental volume of the environmental sound stored in the memory.

3. The speech sound response device of claim 2, wherein the processor is configured to determine the environmental volume periodically from the sound.

4. The speech sound response device of claim 3, wherein the processor is configured to determine the environmental volume based on an average volume of the environmental sound over a period of time.

5. A speech sound response method using a speech sound response device, the method comprising:
acquiring, by a processor, a sound input from a microphone;
detecting, by the processor, a voice in the sound input;
generating, by the processor, a response to the voice;
determining, by the processor, a response volume for outputting the response based on (i) a voice volume of the voice in the sound input and (ii) an environmental volume of an environmental sound other than the voice; and
controlling, by the processor, a speaker to output the response at the response volume **characterised in that**
the method further comprises:
the method **characterized by** further comprising:
storing, by the processor, a plurality of volume functions in a memory, wherein each of the plurality of volume functions (i) corresponds to a loudness of the environmental volume of the environmental sound and (ii) relates the response volume to a loudness of the voice volume; and
selecting, by the processor, one of the plurality of volume functions based on the environmental volume; and
determining, by the processor, the response volume of the response using the one of the plurality of volume functions and the voice volume.

6. The method according to claim 5, further comprising:
monitoring, by the processor, the sound input acquired from the microphone;
determining, by the processor, the environmental volume from the sound input in response to not detecting the voice in the sound input;
store the environmental volume in a memory; and
determine the response volume of the response based on the voice volume detected in the sound input and the environmental volume of the environmental sound stored in the memory.

7. The method of claim 6, wherein the processor is configured to determine the environmental volume periodically from the sound input.

8. The method of claim 7, wherein the processor is configured to determine the environmental volume based on an average volume of the environmental sound over a period of time.

9. A computer program product comprising instructions which, when the program is executed by a computer, cause the computer to carry out the steps of the method according to any one of claims 5-8.

## Patentansprüche

1. Sprachschallantwortvorrichtung, umfassend (1):
ein Mikrofon (2), das konfiguriert ist, um Schall zu erfassen;
einen Lautsprecher (3); und
einen Prozessor (11), der zu Folgendem konfiguriert ist:
Erfassen einer Stimme in dem Schall;
Erzeugen einer Antwort auf die Stimme;
Bestimmen einer Antwortlautstärke zum Ausgeben der Antwort basierend auf (i) einer Stimmlautstärke der Stimme in dem Schall und (ii) einer Umgebungslautstärke eines anderen Umgebungsschalls als der Stimme; und
Steuern des Lautsprechers, um die Antwort mit der Antwortlautstärke auszugeben,
wobei die Sprachschallantwortvorrichtung **dadurch gekennzeichnet ist, dass** sie ferner eine Speichervorrichtung umfasst, die konfiguriert ist, um eine Vielzahl von Lautstärkefunktionen speichert, wobei jede der Vielzahl von Lautstärkefunktionen (i) einer Lautstärke der Umgebungslautstärke des Umgebungsschalls entspricht und (ii) die Antwortlautstärke mit einer Lautstärke der Sprachlautstärke in Beziehung setzt, und wobei der Prozessor konfiguriert ist, um eine der Vielzahl von Lautstärkefunktionen basierend auf der Umgebungslautstärke auszuwählen und die Antwortlautstärke der Antwort unter Verwendung der einen von der Vielzahl von Lautstärkefunktionen basierend auf der Sprachlautstärke zu bestimmen.

2. Sprachschallantwortvorrichtung nach Anspruch 1, ferner umfassend einen Speicher, der konfiguriert ist, um die Umgebungslautstärke des Umgebungsschalls zu speichern, wobei der Prozessor zu Folgendem konfiguriert ist:
Überwachen des Schalls, der von dem Mikrofon erfasst wird;
Bestimmen der Umgebungslautstärke aus dem Schall als Reaktion darauf, dass die Stimme in dem Schall nicht erfasst wird;
Speichern der Umgebungslautstärke in dem Speicher; und
Bestimmen der Antwortlautstärke der Antwort basierend auf der Stimmlautstärke, die in dem Schall erkannt wird, und der Umgebungslautstärke des Umgebungsschalls, die in dem Speicher gespeichert ist.

3. Sprachschallantwortvorrichtung nach Anspruch 2, wobei der Prozessor konfiguriert ist, um die Umgebungslautstärke periodisch aus dem Schall zu bestimmen.

4. Sprachschallantwortvorrichtung nach Anspruch 3, wobei der Prozessor konfiguriert ist, um die Umgebungslautstärke basierend auf einer durchschnittlichen Lautstärke des Umgebungsschalls über einen Zeitraum zu bestimmen.

5. Sprachschallantwortverfahren unter Verwendung einer Sprachschallantwortvorrichtung, das Verfahren umfassend:
Erfassen, durch einen Prozessor, eines Schalleingangs von einem Mikrofon;
Erkennen, durch den Prozessor, einer Stimme in dem Schalleingang;
Erzeugen, durch den Prozessor, einer Antwort auf die Stimme;
Bestimmen, durch den Prozessor, einer Antwortlautstärke zum Ausgeben der Antwort basierend auf (i) einer Stimmlautstärke der Stimme in dem Schalleingang und (ii) einer Umgebungslautstärke eines anderen Umgebungsschalls als der Stimme; und
Steuern, durch den Prozessor, eines Lautsprechers, um die Antwort mit der Antwortlautstärke auszugeben, **dadurch gekennzeichnet, dass** das Verfahren ferner Folgendes umfasst:
wobei das Verfahren **dadurch gekennzeichnet ist, dass** es ferner Folgendes umfasst:
Speichern, durch den Prozessor, einer Vielzahl von Lautstärkefunktionen in einem Speicher,
wobei jede der Vielzahl von Lautstärkefunktionen (i) einer Lautstärke der Umgebungslautstärke des Umgebungsschalls entspricht und (ii) die Antwortlautstärke mit einer Lautstärke der Stimmlautstärke in Beziehung setzt; und
Auswählen, durch den Prozessor, einer der mehreren Lautstärkefunktionen basierend auf der Umgebungslautstärke; und
Bestimmen, durch den Prozessor, der Antwortlautstärke der Antwort unter Verwendung der einen der Vielzahl von Lautstärkefunktionen und der Stimmlautstärke.

6. Verfahren nach Anspruch 5, ferner umfassend:
Überwachung, durch den Prozessor, des Schalleingangs, der von dem Mikrofon erfasst wird;
Bestimmen, durch den Prozessor, der Umgebungslautstärke aus dem Schalleingang als Reaktion darauf, dass die Stimme in dem Schalleingang nicht erfasst wird;
Speichern der Umgebungslautstärke in einem Speicher; und
Bestimmen der Antwortlautstärke der Antwort basierend auf der Stimmlautstärke, die in dem Schalleingang erkannt wird, und der Umgebungslautstärke des Umgebungsschalls, die in dem Speicher gespeichert ist.

7. Verfahren nach Anspruch 6, wobei der Prozessor konfiguriert ist, um die Umgebungslautstärke periodisch aus dem Schalleingang zu bestimmen.

8. Verfahren nach Anspruch 7, wobei der Prozessor konfiguriert ist, um die Umgebungslautstärke basierend auf einer durchschnittlichen Lautstärke des Umgebungsschalls über einen Zeitraum zu bestimmen.

9. Computerprogrammprodukt, umfassend Anweisungen, die, wenn das Programm von einem Computer ausgeführt wird, den Computer veranlassen, die Schritte des Verfahrens nach einem der Ansprüche 5-8 durchzuführen.

## Revendications

1. Dispositif de réponse à un son vocal comprenant (1) :
un microphone (2) configuré de manière à acquérir un son ;
un haut-parleur (3) ; et
un processeur (11) configuré de manière à :
détecter une voix dans le son ;
générer une réponse à la voix ;
déterminer un volume de réponse pour fournir en sortie la réponse sur la base (i) d'un volume vocal de la voix dans le son et (ii) du volume environnemental d'un son environnemental autre que la voix ; et
commander le haut-parleur afin qu'il fournisse en sortie la réponse avec le volume de réponse, le dispositif de réponse à un son vocal étant **caractérisé en ce qu'**il comprend en outre :
un dispositif de stockage configuré de manière à stocker une pluralité de fonctions de volume, dans lequel chacune de la pluralité de fonctions de volume (i) correspond à une intensité du volume environnemental du son environnemental, et (ii) associe le volume de réponse à une intensité du volume vocal, et dans lequel le processeur est configuré de manière à sélectionner l'une de la pluralité de fonctions de volume sur la base du volume environnemental et à déterminer le volume de réponse de la réponse en utilisant ladite une de la pluralité de fonctions de volume sur la base du volume vocal.

2. Dispositif de réponse à un son vocal selon la revendication 1, comprenant en outre une mémoire configurée de manière à stocker le volume environnemental du son environnemental, dans lequel le processeur est configuré de manière à :
surveiller le son acquis par le microphone ;
déterminer le volume environnemental à partir du son en réponse à la non-détection de la voix dans le son ;
stocker le volume environnemental dans la mémoire ; et
déterminer le volume de réponse de la réponse sur la base du volume vocal détecté dans le son et du volume environnemental du son environnemental stocké dans la mémoire.

3. Dispositif de réponse à un son vocal selon la revendication 2, dans lequel le processeur est configuré de manière à déterminer le volume environnemental périodiquement à partir du son.

4. Dispositif de réponse à un son vocal selon la revendication 3, dans lequel le processeur est configuré de manière à déterminer le volume environnemental sur la base d'un volume moyen du son environnemental sur une période de temps.

5. Procédé de réponse à un son vocal utilisant un dispositif de réponse à un son vocal, le procédé comprenant le fait de :
acquérir, par le biais d'un processeur, une entrée sonore en provenance d'un microphone ;
détecter, par le biais du processeur, une voix dans l'entrée sonore ;
générer, par le biais du processeur, une réponse à la voix ;
déterminer, par le biais du processeur, un volume de réponse pour fournir en sortie la réponse sur la base (i) d'un volume vocal de la voix dans l'entrée sonore et (ii) du volume environnemental d'un son environnemental autre que la voix ; et
commander, par le biais du processeur, un haut-parleur pour fournir en sortie la réponse, avec le volume de réponse, **caractérisé en ce que** le procédé comprend en outre le fait de :
stocker, par le biais du processeur, une pluralité de fonctions de volume dans une mémoire, dans laquelle chacune de la pluralité de fonctions de volume (i) correspond à une intensité du volume environnemental du son environnemental et (ii) associe le volume de réponse à une intensité du volume vocal ; et
sélectionner, par le biais du processeur, l'une de la pluralité de fonctions de volume sur la base du volume environnemental ; et
déterminer, par le biais du processeur, le volume de réponse de la réponse en utilisant l'une de la pluralité de fonctions de volume et le volume vocal.

6. Procédé selon la revendication 5, comprenant en outre le fait de :
surveiller, par le biais du processeur, l'entrée sonore acquise à partir du microphone ;
déterminer, par le biais du processeur, le volume environnemental à partir de l'entrée sonore en réponse à la non-détection de la voix dans l'entrée sonore ;
stocker le volume environnemental dans une mémoire ; et
déterminer le volume de réponse de la réponse sur la base du volume vocal détecté dans l'entrée sonore et du volume environnemental du son environnemental stocké dans la mémoire.

7. Procédé selon la revendication 6, dans lequel le processeur est configuré de manière à déterminer le volume environnemental périodiquement à partir de l'entrée sonore.

8. Procédé selon la revendication 7, dans lequel le processeur est configuré de manière à déterminer le volume environnemental sur la base d'un volume moyen du son environnemental sur une période de temps.

9. Produit-programme informatique comprenant des instructions qui, lorsque le programme est exécuté par un ordinateur, amènent l'ordinateur à mettre en œuvre les étapes du procédé selon l'une quelconque des revendications 5 à 8.
